# EUROPEAN PATENT APPLICATION

(11) **EP 2 955 776 A1**
(43) Date of publication of application: **16.12.2015**
(21) Application number: 14748881.1
(22) Date of filing: 07.02.2014
(51) Int. Cl.: H01M 4/90, B01J 27/24, H01M 8/10

(54) **OXYGEN REDUCTION CATALYST, OXYGEN REDUCTION ELECTRODE, AND FUEL CELL**

(30) Priority: 07.02.2013 JP 2013021911
(71) Applicant: IHI Corporation, Tokyo 135-8710 (JP)
(72) Inventor: YOSHIMURA, Akihiko, Tokyo 135-8710 (JP); MATSUO, Takahiro, Tokyo 135-8710 (JP); KAWAGUCHI, Norihito, Tokyo 135-8710 (JP); YOSHIHISA, Kumiko, Tokyo 135-8710 (JP); TACHIBANA, Masaru, Yokohama-shi Kanagawa 236-0027 (JP); SHIN, Seog Chul, Yokohama-shi Kanagawa 236-0027 (JP)
(74) Representative: Lamb, Martin John Carstairs
(86) International application number: PCT/JP2014/052860
(87) International publication number: WO 2014/123213

(57) **Abstract**

The present invention relates to an oxygen reduction catalyst, an oxygen reduction electrode, and a fuel cell each of which has a carbon nanowall doped with nitrogen. According to the present invention, the oxygen reduction catalyst, the oxygen reduction electrode and the fuel cell can be provided at low cost.

## Description

### Technical Field

The present invention relates to an oxygen reduction catalyst, an oxygen reduction electrode and a fuel cell each of which utilizes a carbon nanowall.

### Background Art

Recently, as a source of clean energy, fuel cells have been focused. There are several kinds of fuel cells, and a solid polymer type fuel cell, which is a kind of them, utilizes a carbon material that carries platinum, as a catalyst for its electrode. For example, platinum may be allowed to be carried on a carbon nanowall and this is usable as a catalyst. However, platinum is a rare and expensive material. Thus, such an electrode that utilizes the carbon material carrying platinum as the catalyst requires high manufacturing cost. Accordingly, the use of platinum has been one of the causes of the insufficient prevalence of fuel cells.

As a material that can be utilized for the catalyst as a substitute for the carbon material carrying platinum, a carbon material doped with nitrogen has been proposed (see Non Patent Literature 1 or 2, for example). Since nitrogen is an easily available material, if using nitrogen as a material for the catalyst, it is possible to produce the catalyst which is to be utilized for the fuel cell, at low cost.

### Citation List

### Non Patent Literatures

Non Patent Literature 1: Kuanping Gong and four others, "Nitrogen-Doped Carbon Nanotube Arrays with High Electocatalytic Activity for Oxygen Reduction", Science vol. 323, p. 760-764, February 2009
Non Patent Literature 2: Liangti Qu and three others, "Nitrogen-Doped Graphene as Efficient Metal-Free Electorocatalyst for Ocygen Reduction in Fuel Cells" ACS Nano. 4, 2008

### Summary of Invention

### Technical Problem

As described above, the conventional method had the problem of increasing the manufacturing cost of the electrode because of using platinum for the catalyst.

In the light of the problem described above, an object of the present invention is to provide an oxygen reduction catalyst, an oxygen reduction electrode and a fuel cell easily at low cost.

### Solution to Problem

In order to achieve the above-described object, according to a first invention, an oxygen reduction catalyst having a carbon nanowall doped with nitrogen is possibly provided.

Moreover, according to a second invention, the oxygen reduction catalyst in which an amount of the nitrogen that is doped into the carbon nanowall ranges from 0.5 at% to 20.0 at% is possibly provided.

Further, according to a third invention, the oxygen reduction catalyst in which a degree of crystallinity of the carbon nanowall doped with nitrogen ranges from 0.5 to 3.5 is possibly provided.

Furthermore, according to a fourth invention, an oxygen reduction electrode comprising: a gas diffusion layer; and a catalyst layer which is arranged on the gas diffusion layer and which is of the oxygen reduction catalyst provided according to any one of the first to third inventions.

Moreover, according to a fifth invention, the oxygen reduction electrode wherein the gas diffusion layer is of a carbon substrate and the catalyst layer is of the oxygen reduction catalyst formed on the gas diffusion layer that is made of the carbon substrate is possibly provided.

Further, according to a sixth invention, the oxygen reduction electrode in which the catalyst layer is 1 µm or more can be provided.

Furthermore, according to a seventh invention, a fuel cell comprising: an electrolyte membrane; the oxygen reduction electrodes which are respectively arranged on both sides of the electrolyte membrane and are provided according to any one of the fourth to sixth inventions; and separators that are respectively positioned outside the electrodes, is possibly provided.

### Advantageous Effects of Invention

According to the present invention, it is possible to provide the oxygen reduction catalyst, the oxygen reduction electrode and the fuel cell at low cost.

### Brief Description of Drawings

Fig. 1 is a schematic drawing that explains a structure of an apparatus for producing a carbon nanowall which is to be utilized for an oxygen reduction catalyst according to a first embodiment.
Fig. 2(a) is an XPS spectrum of the carbon nanowall produced on a silicon substrate, Fig. 2(b) is an XPS spectrum of the carbon nanowall, and Fig. 2(c) is an XPS spectrum of pieces of the carbon nanowall.
Fig. 3 is a schematic drawing that explains a fuel cell.
Fig. 4 is a SEM image of a carbon nanowall according to Example 1.
Fig. 5(a) is a Raman scattering spectrum of the carbon nanowall according to Example 1, Fig. 5(b) is an XPS spectrum of the carbon nanowall according to Example 1, Fig. 5(c) is a Raman scattering spectrum of pieces of the carbon nanowall according to Example 1, and Fig. 5(d) is an XPS spectrum of the carbon nanowall pieces according to Example 1.
Fig. 6(a) is a Raman scattering spectrum of a carbon nanowall according to Example 2, Fig. 6(b) is an XPS spectrum of the carbon nanowall according to Example 2, Fig. 6(c) is a Raman scattering spectrum of pieces of the carbon nanowall according to Example 2, and Fig. 6(d) is an XPS spectrum of the carbon nanowall pieces according to Example 2.
Fig. 7(a) is a Raman scattering spectrum of a carbon nanowall according to Example 3, Fig. 7(b) is an XPS spectrum of the carbon nanowall according to Example 3, Fig. 7(c) is a Raman scattering spectrum of pieces of the carbon nanowall according to Example 3, and Fig. 7(d) is an XPS spectrum of the carbon nanowall pieces according to Example 3.
Fig. 8 is a graph that illustrates catalytic properties of the carbon nanowalls according to Examples 1 to 3.
Figs. 9(a) and 9(b) are SEM images of a carbon nanowall which is utilized for an oxygen reduction catalyst according to a second embodiment.
Fig. 10 is an XPS spectrum of the carbon nanowall which is utilized for the oxygen reduction catalyst according to the second embodiment.

### Description of Embodiments

### <First Embodiment>

An oxygen reduction catalyst according to a first embodiment is a carbon nanowall doped with nitrogen or nitrogen-doped carbon nanowall pieces. Moreover, an oxygen reduction electrode according to the first embodiment includes: a gas diffusion layer; and an oxygen reduction catalyst that is to be a catalyst layer. Further, a fuel cell according to the first embodiment comprises: an electrolyte membrane; a gas diffusion layer; an oxygen reduction catalyst that is to be the catalyst layer; and a separator.

### (Oxygen Reduction Catalyst)

The oxygen reduction catalyst according to the first embodiment is the carbon nanowall doped with nitrogen or carbon nanowall pieces composed of one or plural domains of nanographite which are smaller than the carbon nanowall. The carbon nanowall pieces are obtained by pulverizing the carbon nanowall doped with nitrogen. The carbon nanowall doped with nitrogen is produced on a substrate, for example, a silicon substrate or the like, and it is stripped from the substrate after doped with nitrogen.

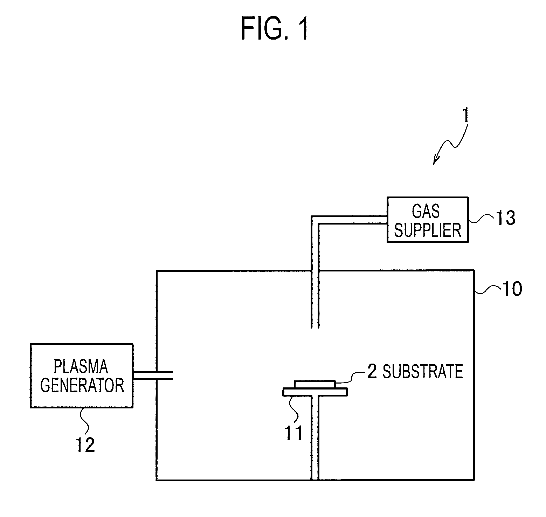

For example, by utilizing an apparatus 1 illustrated in Fig. 1, the carbon nanowall produced on the substrate is possibly doped with nitrogen. The apparatus 1 shown in Fig. 1 includes: a reaction chamber 10 that is a sealable space; a supporting device 11 that supports a substrate 2; a plasma generator 12 that generates plasma to supply the plasma into the reaction chamber 10; and a gas supplier 13 that supplies gas containing nitrogen (hereinafter, denoted as "nitrogen gas") into the reaction chamber 10.

For example, the substrate 2 on which the carbon nanowall is produced is placed on the supporting device 11 in the reaction chamber 10, and thereafter, the nitrogen gas is supplied into the reaction chamber 10 by the gas supplier 13. This reaction chamber 10 is structured so that other gas such as air may not enter from outside, while the carbon nanowall on the substrate 2 is doped with nitrogen. Moreover, it is preferred that the supporting device 11 possibly fixes the substrate 2 thereto. Further, the nitrogen gas supplied by the gas supplier 13 may be a gas that contains nitrogen and does not cause chemical reaction with carbon, and it is, for example, a mixed gas of argon and nitrogen.

Next, plasma is generated by the plasma generator 12 using a discharge gas for generating plasma, and the generated plasma is supplied into the reaction chamber 10. Subsequently, in the reaction chamber 10, the carbon nanowall on the substrate 2 is doped with nitrogen, which is contained in the nitrogen gas supplied by the gas supplier 13, by the plasma supplied from the plasma generator 12. That is, nitrogen atoms of the nitrogen gas are excited and ionized by the plasma, so that the carbon nanowall is doped therewith. Thus, the atoms that compose the nitrogen are possibly put into the carbon structure that constitutes the carbon nanowall.

Alternatively, it is also possible to support a substrate 2 on which the carbon nanowall is not produced, by the supporting device 11 of the reaction chamber 10, and to produce then the carbon nanowall on the substrate 2 by utilizing the apparatus 1, thereafter doping the carbon nanowall with the nitrogen by utilizing the apparatus 1 as described above.

A method for stripping the carbon nanowall doped with nitrogen from the substrate 2 is not limited, but may be, for example, a method utilizing a scraper. Moreover, a method for pulverizing the carbon nanowall that is stripped from the substrate 2 is also not limited, and an example of carbon nanowall pieces which are obtained by pulverizing the carbon nanowall manually with an agate mortar for 20 minutes will be described below.

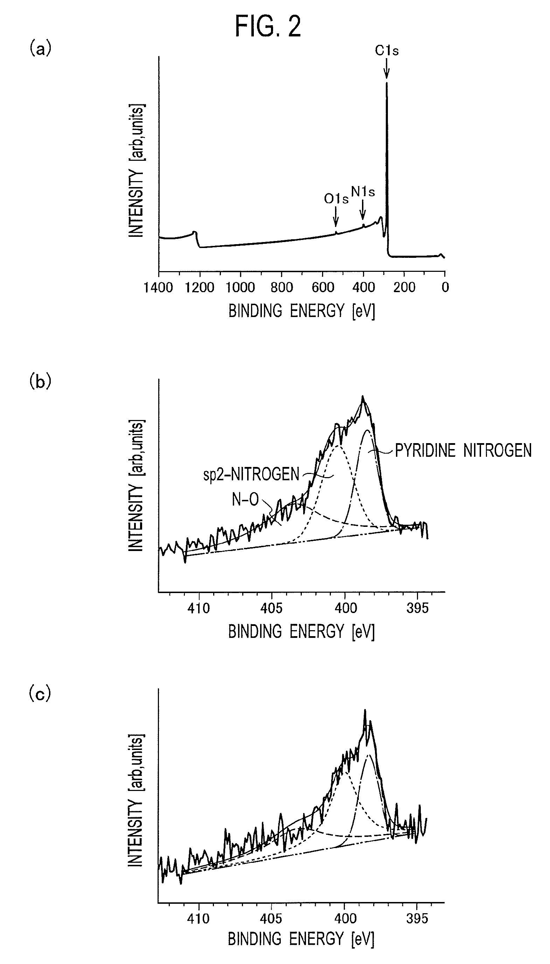

For example, the carbon nanowall doped with nitrogen, which is the oxygen reduction catalyst according to the first embodiment, provides XPS spectra which are shown in Figs. 2(a) to 2(c) as an example thereof. In the example shown in Figs. 2(a) to 2(c), the horizontal axis represents the binding energy [eV], and the vertical axis represents the intensity [arb. units].

Fig. 2(a) is the XPS spectrum of the carbon nanowall doped with nitrogen, which is obtained by analyzing the carbon nanowall produced on the silicon substrate as it is. The carbon nanowall illustrated in Fig. 2(a) is obtained by: producing the carbon nanowall on the silicon substrate under Condition A1 by using the apparatus 1; and thereafter doping the carbon nanowall on the silicon substrate with nitrogen under Condition A2.

Condition A1: pressure of 0.67 Pa; heating temperature of 700°C; a discharge current of 70 A; a flow rate of argon of 80 sccm; a flow rate of hydrogen of 10 sccm; a flow rate of methane of 10 sccm; and a growth time of 360 minutes.

Condition A2: pressure of 0.36 Pa; heating temperature of 600°C; a discharge current of 50 A; a flow rate of argon of 80 sccm; a flow rate of hydrogen of 10 sccm; a flow rate of nitrogen of 10 sccm; and a processing time of 5 minutes.

A composition ratio of the carbon nanowall of Fig. 2(a) is: 97.08 at% of carbon (C1s); 2.06 at% of nitrogen (N1s); and 0.86 at% of oxygen (O1s). Incidentally, in the example shown in Fig. 2(a), an amount of the nitrogen that is doped in the carbon nanowall is 2.06 at%, and an amount of nitrogen that is doped in the oxygen reduction catalyst preferably ranges from about 0.5 at% to about 20.0 at%.

Further, Fig. 2(b) is an XPS spectrum regarding the nitrogen of the carbon nanowall which is the same as that of Fig. 2(a). Moreover, Fig. 2(c) is an XPS spectrum regarding nitrogen of the carbon nanowall pieces which are obtained by pulverizing the carbon nanowall of Fig. 2(a). From the comparison of Figs. 2(b) and 2(c), it is known that its property is not changed due to the pulverization. Incidentally, as the oxygen reduction catalyst, an area ratio of pyridine nitrogen to sp2 nitrogen in the XPS spectrum preferably ranges from 1 : 0.4 to 1 : 1.5. Further, as the oxygen reduction catalyst, a degree of crystallinity (ID/IG) obtained by an intensity ratio of the D-band to the G-band in a Raman scattering spectrum preferably ranges from 0.5 to 3.5.

### (Electrode)

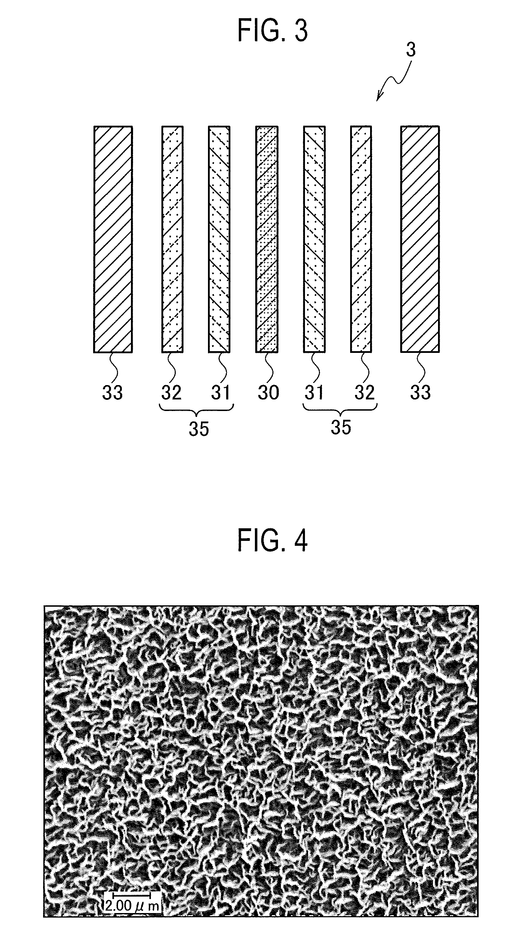

As illustrated in Fig. 3, an electrode 35 according to the first embodiment has a catalyst layer 31 and a gas diffusion layer 32. The catalyst layer 31 is of the oxygen reduction catalyst according to the first embodiment. Further, the gas diffusion layer 32 is to supply gas such as air or the like to the catalyst layer 31, which is of, for example, carbon paper or carbon cloth. In the electrode 35, the catalyst layer 31 is provided so as to deposit the oxygen reduction catalyst on one surface of the gas diffusion layer 32. Here, in order to obtain a preferable catalytic property, a thickness of the catalyst layer 31 is preferably 1 µm or more.

### (Fuel Cell)

As shown in Fig. 3, a fuel cell 3 according to the first embodiment has: an electrolyte membrane 30; the catalyst layers 31 that are positioned on both sides of the electrolyte membrane 30; gas diffusion layers 32 that are respectively positioned outside the catalyst layers 31; and separators 33 that are respectively positioned outside the gas diffusion layers 32. The catalyst layers 31 are of the oxygen reduction catalyst according to the first embodiment.

As described above, the oxygen reduction catalyst according to the first embodiment can be produced at low cost by utilizing the nitrogen-doped carbon nanowall or carbon nanowall pieces. Also, by utilizing the oxygen reduction catalyst according to the first embodiment, the electrode and the fuel cell can be produced at low cost.

### <Example 1>

Fig. 4 illustrates a SEM image of the carbon nanowall according to Example 1. This carbon nanowall doped with nitrogen was obtained by: producing a carbon nanowall on a silicon substrate under Condition B1 by utilizing the apparatus 1 that was described above with reference to Fig. 1; and subsequently doping the carbon nanowall on the silicon substrate with nitrogen under Condition B2.

Condition B1: pressure of 0.67 Pa; heating temperature of 600°C; a discharge current of 50 A; a flow rate of argon of 80 sccm; a flow rate of hydrogen of 10 sccm; a flow rate of methane of 10 sccm; and a growth time of 360 minutes.

Condition B2: pressure of 0.67 Pa; heating temperature of 700°C; a discharge current of 70 A; a flow rate of argon of 80 sccm; a flow rate of hydrogen of 0 sccm; a flow rate of nitrogen of 20 sccm; and a processing time of 1 minute.

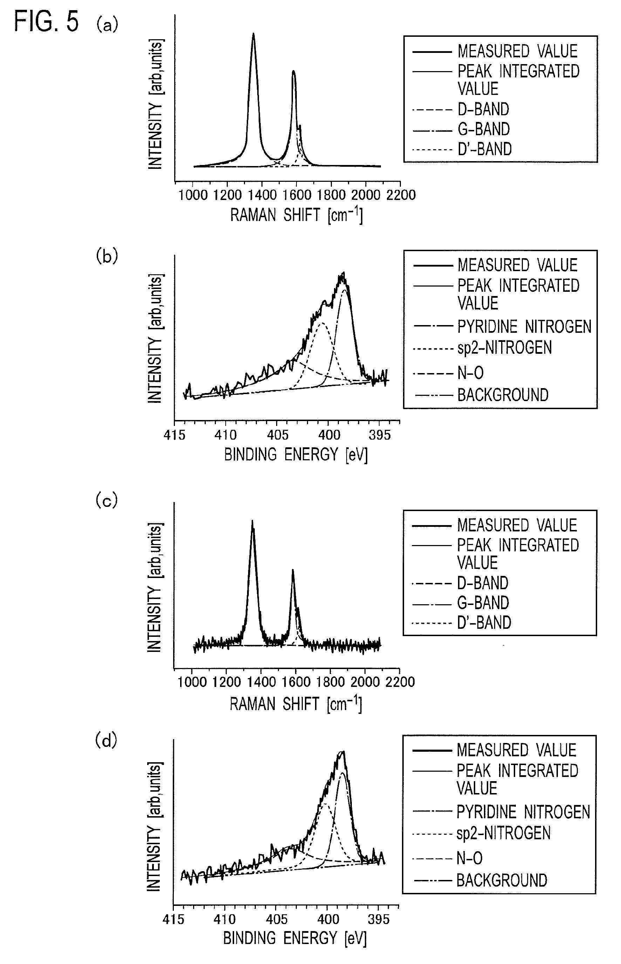

Fig. 5(a) illustrates a Raman scattering spectrum of the carbon nanowall doped with nitrogen of Example 1. Fig. 5(b) illustrates an XPS spectrum of the carbon nanowall of Example 1. Fig. 5(c) illustrates a Raman scattering spectrum of carbon nanowall pieces that are obtained by pulverizing the carbon nanowall of Example 1. Fig. 5(d) illustrates an XPS spectrum of the carbon nanowall pieces that are obtained by pulverizing the carbon nanowall of Example 1.

In the Raman scattering spectra of Figs. 5(a) and 5(c), the horizontal axis represents the Raman shift [cm-1], and the vertical axis represents Raman scattering intensity [arb. units]. Specifically, in each of these Raman scattering spectra, the measured value; a peak integrated value obtained by peak fitting; the D-band; the G-band; and the D'-band are shown.

In the XPS spectra shown in Figs. 5(b) and 5(d), the horizontal axis represents binding energy [eV], and the vertical axis represents intensity [arb. units]. Specifically, in each of these XPS spectra, the measured value; a peak integrated value obtained by peak fitting; pyridine nitrogen; sp2 nitrogen; nitrogen bonded with oxygen (N-O); and the background are shown.

In the example illustrated in Figs. 5(a) to 5(d), in regard to the carbon nanowall before the pulverization, the content of nitrogen was 2.2 at%; the content of pyridine nitrogen was 0.78 at%; the content of sp2 nitrogen was 0.62 at%; the content ratio of the pyridine nitrogen to the sp2 nitrogen was 1.25; and the degree of crystallinity (ID/IG) was 1.42. Further, in regard to the carbon nanowall pieces after the pulverization, the content of nitrogen was 1.88 at%; the content of pyridine nitrogen was 0.61 at%; the content of sp2 nitrogen was 0.66 at%; the content ratio of the pyridine nitrogen and the sp2 nitrogen was 0.92; and the degree of crystallinity (ID/IG) was 1.89.

### <Example 2>

A carbon nanowall doped with nitrogen of Example 2 was obtained by: producing a carbon nanowall on a silicon substrate under Condition C1 by utilizing the apparatus 1 that was described above with reference to Fig. 1; and doping the carbon nanowall on the silicon substrate with nitrogen under Condition C2.

Condition C1: pressure of 0.67 Pa; heating temperature of 800°C; a discharge current of 50 A; a flow rate of argon of 80 sccm; a flow rate of hydrogen of 0 sccm; a flow rate of methane of 20 sccm; and a growth time of 360 minutes.

Condition C2: pressure of 0.67 Pa; heating temperature of 800°C; a discharge current of 50 A; a flow rate of argon of 80 sccm; a flow rate of hydrogen of 10 sccm; a flow rate of nitrogen of 10 sccm; and a processing time of 1 minute.

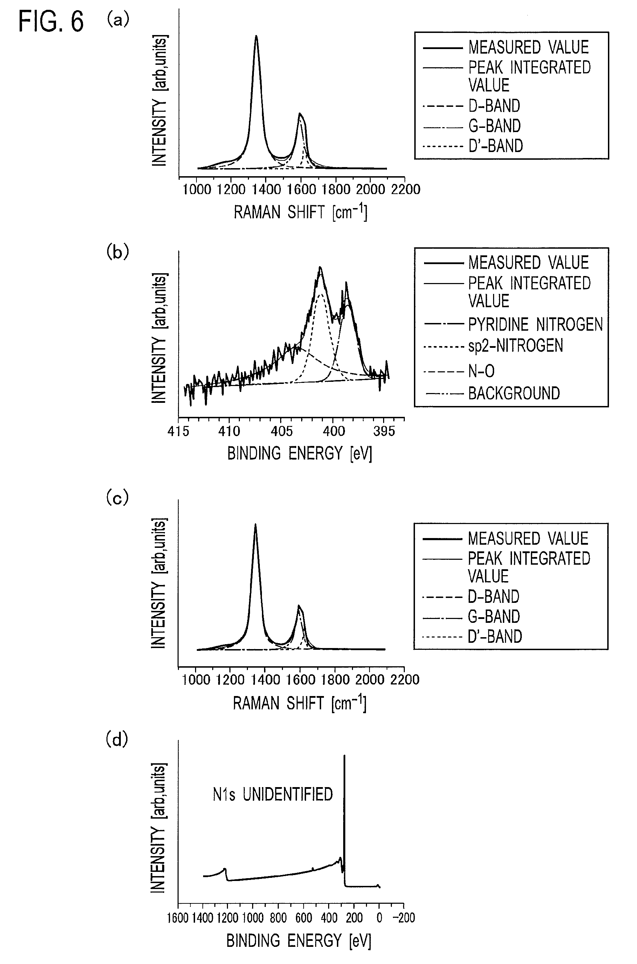

Fig. 6(a) illustrates a Raman scattering spectrum of the carbon nanowall doped with nitrogen of Example 2. Fig. 6(b) illustrates an XPS spectrum of the carbon nanowall of Example 2. Fig. 6(c) illustrates a Raman scattering spectrum of carbon nanowall pieces that are obtained by pulverizing the carbon nanowall of Example 2. Fig. 6(d) illustrates an XPS spectrum of the carbon nanowall pieces that are obtained by pulverizing the carbon nanowall of Example 2. In Figs. 6(a) and 6(c), the horizontal axis represents the Raman shift, and the vertical axis represents Raman scattering intensity, similar to Figs. 5(a) and 5(c). In Figs. 6(b) and 6(d), the horizontal axis represents binding energy, and the vertical axis represents intensity, similar to Figs. 5(b) and 5(d).

In the example illustrated in Figs. 6(a) to 6(d), in regard to the carbon nanowall before the pulverization, the content of nitrogen was 2.88 at%; the content of pyridine nitrogen was 0.72 at%; the content of sp2 nitrogen was 0.87 at%; the content ratio of the pyridine nitrogen to the sp2 nitrogen was 0.82; and the degree of crystallinity (ID/IG) was 2.65. Further, in regard to the carbon nanowall pieces after the pulverization, the content of nitrogen, the content of pyridine nitrogen, the content of sp2 nitrogen, and the content ratio of the pyridine nitrogen to the sp2 nitrogen were not identified, and the degree of crystallinity (ID/IG) was 3.11.

### <Example 3>

A carbon nanowall doped with nitrogen of Example 3 was obtained by: producing a carbon nanowall on a silicon substrate under Condition D1 by utilizing the apparatus 1 that was described above with reference to Fig. 1; and doping the carbon nanowall on the silicon substrate with nitrogen under Condition D2.

Condition D1: pressure of 0.67 Pa; heating temperature of 700°C; a discharge current of 70 A; a flow rate of argon of 80 sccm; a flow rate of hydrogen of 10 sccm; a flow rate of methane of 10 sccm; and a growth time of 360 minutes.

Condition D2: pressure of 0.36 Pa; heating temperature of 600°C; a discharge current of 50 A; a flow rate of argon of 80 sccm; a flow rate of hydrogen of 10 sccm; a flow rate of nitrogen of 10 sccm; and a processing time of 5 minutes.

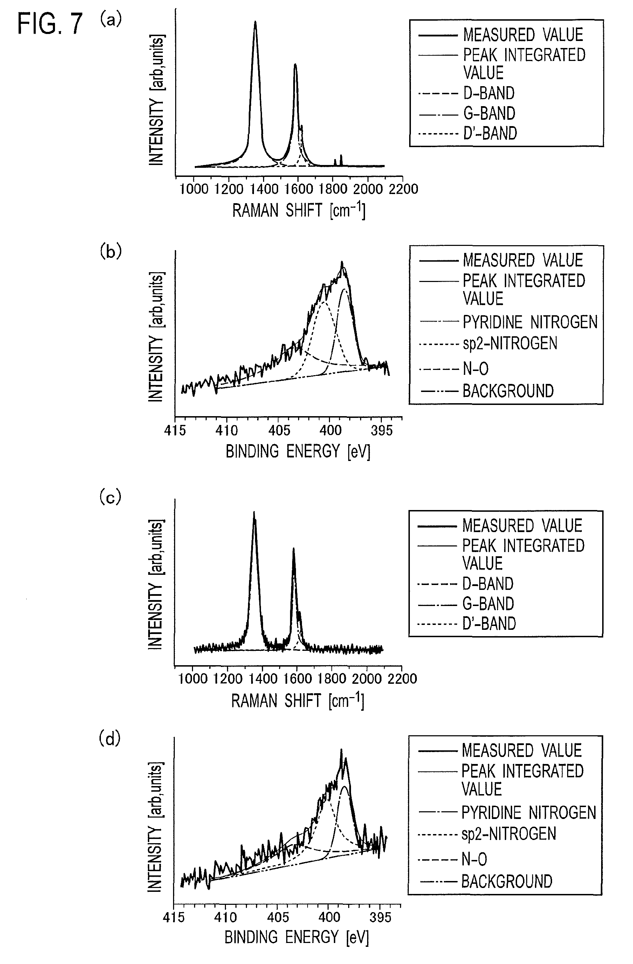

Fig. 7(a) illustrates a Raman scattering spectrum of the carbon nanowall doped with nitrogen of Example 3. Fig. 7(b) illustrates an XPS spectrum of the carbon nanowall of Example 3. Fig. 7(c) illustrates a Raman scattering spectrum of carbon nanowall pieces that are obtained by pulverizing the carbon nanowall of Example 3. Fig. 7(d) illustrates an XPS spectrum of the carbon nanowall pieces that are obtained by pulverizing the carbon nanowall of Example 3. In Figs. 7(a) and 7(c), the horizontal axis represents the Raman shift, and the vertical axis represents Raman scattering intensity, similar to Figs. 5(a) and 5(c). In Figs. 7(b) and 7(d), the horizontal axis represents binding energy, and the vertical axis represents intensity, similar to Figs. 5(b) and 5(d).

In the example illustrated in Figs. 7(a) to 7(d), in regard to the carbon nanowall before the pulverization, the content of nitrogen was 2.06 at%; the content of pyridine nitrogen was 0.53 at%; the content of sp2 nitrogen was 0.70 at%; the content ratio of the pyridine nitrogen to the sp2 nitrogen was 0.76; and the degree of crystallinity (ID/IG) was 1.49. Further, in regard to the carbon nanowall pieces after the pulverization, the content of nitrogen was 0.98 at%; the content of pyridine nitrogen was 0.23 at%; the content of sp2 nitrogen was 0.44 at%; the content ratio of the pyridine nitrogen and the sp2 nitrogen was 0.53; and the degree of crystallinity (ID/IG) was 1.43.

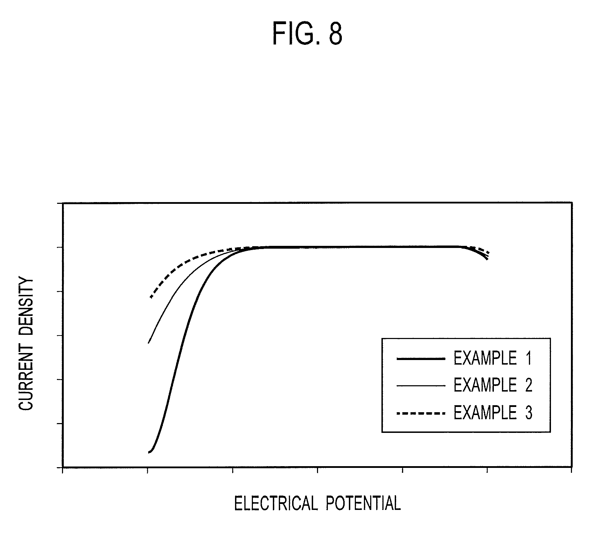

Fig. 8 illustrates catalytic properties of the respective carbon nanowalls of Examples 1 to 3. In Fig. 8, the horizontal axis represents electrical potential and the vertical axis represents current density. In the graph shown in Fig. 8, according as the point at which the graphic curve begins to fall is located on the right side, the catalytic property of the carbon nanowall can be regarded as high. Thus, it can be understood here that the carbon nanowall of Example 1 has the highest catalytic property.

### <Second Embodiment>

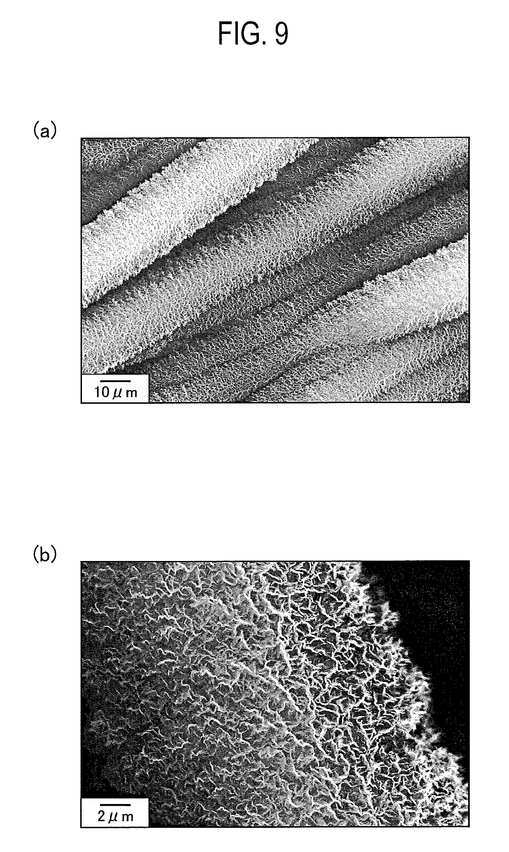

An oxygen reduction catalyst according to a second embodiment is a nitrogen-doped carbon nanowall which is produced on carbon paper or carbon cloth. Figs. 9(a) and 9(b) illustrate an example of SEM images of the oxygen reduction catalyst according to the second embodiment. Moreover, an oxygen reduction electrode according to the second embodiment has: the carbon paper or the carbon cloth that is to be a gas diffusion layer; and the oxygen reduction catalyst that is to be a catalyst layer formed on this gas diffusion layer. Further, a fuel cell according to the second embodiment has: an electrolyte layer; the carbon paper or the carbon cloth that is to be the gas diffusion layer; the oxygen reduction catalyst that is to be the catalyst layer formed on this gas diffusion layer; and a separator. Since an apparatus for producing the oxygen reduction catalyst is the same as the apparatus 1 described above with reference to Fig. 1 in the first embodiment, Fig. 1 will be referred for the following description. Moreover, an electrode and a fuel cell will be described with reference to Fig. 3.

### (Oxygen Reduction Catalyst)

Comparing the oxygen reduction catalyst according to the second embodiment with the oxygen reduction catalyst according to the first embodiment, the oxygen reduction catalyst according to the first embodiment was obtained by: producing the carbon nanowall on the substrate such as a silicon substrate; doping this carbon nanowall with nitrogen; and subsequently stripping this carbon nanowall from the substrate. On the other hand, the oxygen reduction catalyst according to the second embodiment is different from the oxygen reduction catalyst according to the first embodiment in that the carbon nanowall, which is to be doped with nitrogen, is produced on a carbon substrate such as the carbon paper and the carbon cloth. Incidentally, for the production of the carbon nanowall on the carbon substrate and the doping of the carbon nanowall with nitrogen, the apparatus which was described above with reference to Fig. 1 is possibly utilized. At this time, a height of the carbon nanowall formed on the carbon substrate is preferably 1 µm or more.

Figs. 9(a) and 9(b) are the SEM images of an example of the oxygen reduction catalyst according to the second embodiment. The images of Figs. 9(a) and 9(b) are different in magnification. Specifically, they are the SEM images of the nitrogen-doped carbon nanowall which is produced on the carbon paper. The oxygen reduction catalyst shown in Figs. 9(a) and 9(b) is obtained by: producing the carbon nanowall on the carbon paper under Condition E1 by utilizing the apparatus 1 that was described above with reference to Fig. 1; and subsequently doping the carbon nanowall on the carbon paper with nitrogen under Condition E2.

Condition E1: pressure of 0.67 Pa; heating temperature of 700°C; a discharge current of 70 A; a flow rate of argon of 80 sccm; a flow rate of hydrogen of 10 sccm; a flow rate of methane of 10 sccm; and a growth time of 360 minutes.

Condition E2: pressure of 0.67 Pa; heating temperature of 700°C; a discharge current of 70 A; a flow rate of argon of 80 sccm; a flow rate of hydrogen of 0 sccm; a flow rate of nitrogen of 20 sccm; and a processing time of 1 minute.

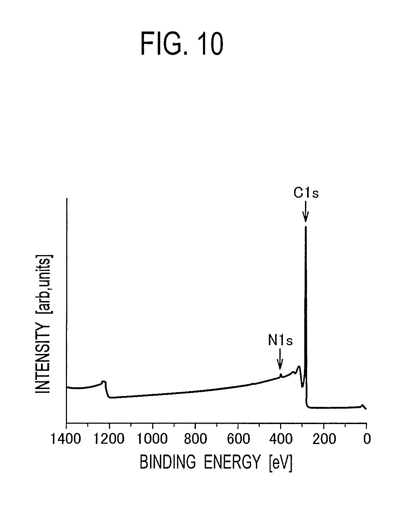

Fig. 10 is an XPS spectrum of the oxygen reduction catalyst according to the second embodiment. In the example shown in Fig. 10, the horizontal axis represents binding energy [eV], and the vertical axis represents intensity [arb. units]. A component ratio of the carbon nanowall of Fig. 10 is: 97.12 at% of carbon; 2.33 at% of nitrogen; and 0.55 at% of oxygen.

Incidentally, similar to the oxygen reduction catalyst according to the first embodiment, an amount of the nitrogen contained in the oxygen reduction catalyst according to the second embodiment preferably ranges from about 0.5 at% to about 20.0 at%. Moreover, as the oxygen reduction catalyst, an area ratio of the pyridine nitrogen to the sp2 nitrogen in the XPS spectrum preferably ranges from 1 : 0.4 to 1 : 1.5. Further, as the oxygen reduction catalyst, the degree of crystallinity (ID/IG) obtained by the intensity ratio of the D-band to the G-band in the Raman scattering spectrum preferably ranges from 0.5 to 3.5.

### (Electrode)

As illustrated in Fig. 3, an electrode 35 according to the second embodiment has a catalyst layer 31 and a gas diffusion layer 32. The catalyst layer 31 is of the oxygen reduction catalyst according to the first embodiment. Further, the gas diffusion layer 32 is of the carbon paper or the carbon cloth that has been utilized as the carbon substrate for the production of the carbon nanowall. Here, the catalyst layer 31 has preferably a thickness of 1 µm or more.

### (Fuel Cell)

As shown in Fig. 3, a fuel cell 3 according to the second embodiment includes: an electrolyte membrane 30; the catalyst layers 31 that are positioned on both sides of the electrolyte film 30; gas diffusion layers 32 that are respectively positioned outside the catalyst layers 31; and separators 33 that are respectively positioned outside the gas diffusion layers 32. The catalyst layers 31 are of the oxygen reduction catalyst according to the second embodiment. Further, the gas diffusion layers 32 are of the carbon paper or the carbon cloth which has been utilized as the carbon substrate for the production of the oxygen reduction catalyst to be the catalyst layer 31.

As described above, the oxygen reduction catalyst according to the second embodiment can be produced at low cost by utilizing the carbon nanowall doped with nitrogen.

Moreover, in the electrode 35 according to the second embodiment, the gas diffusion layer 32 can be of the carbon paper or the carbon cloth which has been utilized as the carbon substrate for the production of the carbon nanowall, and the catalyst layer 31 can be of the oxygen reduction catalyst produced on the gas diffusion layer 32 that is of the carbon substrate. Thus, the electrode 35 according to the second embodiment does not require the process of stripping from the substrate the carbon nanowall that is the oxygen reduction catalyst or the process of depositing the oxygen reduction catalyst to the gas diffusion layer 32, so that the production of the electrode 35 can be realized at the same time as the production of the oxygen reduction catalyst. That is, the electrode 35 that is the oxygen reduction electrode can be produced easily.

Further, since the oxygen reduction catalyst and the electrode 35 can be produced at the same time, the fuel cell 3 can also be produced easily.

As described above, the present invention has been explained in detail by way of the embodiments, but the present invention is not limited to the embodiments that are described in the instant specification. The scope of the present invention shall be determined by the description of the claims and their equivalents.

### Explanation of Reference

- 1: apparatus
- 10: reaction chamber
- 11: supporting device
- 12: plasma generator
- 13: gas supplier
- 2: substrate
- 3: fuel cell
- 30: electrolyte membrane
- 31: catalyst layer
- 32: gas diffusion layer
- 33: separator
- 35: electrode

## Claims

1. An oxygen reduction catalyst, comprising a nitrogen-doped carbon nanowall doped with nitrogen.

2. The oxygen reduction catalyst as set forth in Claim 1, wherein an amount of the nitrogen that is doped into the carbon nanowall ranges from 0.5 at% to 20.0 at%.

3. The oxygen reduction catalyst as set forth in Claim 1 or 2, wherein a degree of crystallinity of the carbon nanowall doped with nitrogen ranges from 0.5 to 3.5.

4. An oxygen reduction electrode, comprising:
a gas diffusion layer; and
a catalyst layer which is arranged on the gas diffusion layer and is of an oxygen reduction catalyst comprising a carbon nanowall doped with nitrogen.

5. The oxygen reduction electrode as set forth in Claim 4, wherein an amount of the nitrogen that is doped into the carbon nanowall ranges from 0.5 at% to 20.0 at%.

6. The oxygen reduction electrode as set forth in Claim 4 or 5, wherein a degree of crystallinity of the carbon nanowall doped with nitrogen ranges from 0.5 to 3.5.

7. The oxygen reduction electrode as set forth in any one of Claims 4 to 6, **characterized in that**
the gas diffusion layer is of a carbon substrate, and
the catalyst layer is of the oxygen reduction catalyst which is formed on the gas diffusion layer that is made of the carbon substrate.

8. The oxygen reduction electrode as set forth in any one of Claims 4 to 7, wherein the catalyst layer is 1 µm or more.

9. A fuel cell, comprising:
an electrolyte membrane;
oxygen reduction electrodes comprising gas diffusion layers that are respectively arranged on both sides of the electrolyte membrane, and catalyst layers which are arranged on the gas diffusion layers and which are of an oxygen reduction catalyst having a carbon nanowall doped with nitrogen; and
separators that are respectively positioned outside the oxygen reduction electrodes.

10. The fuel cell as set forth in Claim 9, **characterized in that** an amount of the nitrogen that is doped into the carbon nanowall of the oxygen reduction electrodes ranges from 0.5 at% to 20.0 at%.

11. The fuel cell as set forth in Claim 9 or 10, wherein a degree of crystallinity of the carbon nanowall doped with nitrogen ranges from 0.5 to 3.5.

12. The fuel cell as set forth in any one of Claims 9 to 11, **characterized in that**
the gas diffusion layers of the oxygen reduction electrodes are of a carbon substrate, and
the catalyst layers of the oxygen reduction electrodes are of the oxygen reduction catalyst formed on the gas diffusion layers that are made of the carbon substrate.

13. The fuel cell as set forth in any one of Claims 9 to 12, wherein the catalyst layers of the oxygen reduction electrodes are 1 µm or more.
